Europäisches Patentamt

European Patent Office

Office européen des brevets

(11) Publication number: **0 288 442**
**A2**

## (12) EUROPEAN PATENT APPLICATION

(21) Application number: **88850112.9**

(22) Date of filing: **30.03.88**

(51) Int. Cl.⁴: **G 12 B 9/02**
**H 05 K 5/02**

(30) Priority: **07.04.87 SE 8701448**

(43) Date of publication of application:
**26.10.88 Bulletin 88/43**

(84) Designated Contracting States:
**AT BE CH DE ES FR GB GR IT LI LU NL SE**

(71) Applicant: **LJUNGMANS INDUSTRIER AB**
**Limhamnsvägen 109**
**S-216 13 Malmö (SE)**

(72) Inventor: **Larsson, Bengt**
**Kalkbrottsgatan 7**
**S-216 12 Malmö (SE)**

(74) Representative: **Rostovanyi, Peter et al**
**AWAPATENT AB Box 5117**
**S-200 71 Malmö (SE)**

(54) **Instrument cabinet.**

(57) Instrument cabinet having rigid walls, which is characterized in that it has a first wall (1) and, fixed thereto, opposed second and third walls (2), opposed fourth and fifth walls (3a, 3b) which are articulated to the first wall (1) or the second and third walls (2), and a sixth wall (3d) which is opposed to the first wall and fixedly connected to the fourth or the fifth wall and provided with means (5) for concealed snap engagement with corresponding means (6, 7) fixed on the fourth or the fifth wall, which snap engagement can be undone from the outside by any of said walls by means of a key.

Fig.2

**Description**

## INSTRUMENT CABINET

The present invention relates to a lockable instrument cabinet having rigid walls, i.e. a cabinet containing instruments, mounting components and connections for the instruments and in principle any components which require regular checking, adjusting, repairing or exchanging, to which end the cabinet must be opened to provide access to said components.

According to the invention, the interior of the cabinet should be difficult of access to unauthorized persons. Another object of the invention is to provide a cabinet which is easy to service, i.e. which can readily be opened by any authorized person so as to provide easy and convenient access to the instruments, mounting components and connections etc. accommodated therein. According to the invention, the cabinet should also be sufficiently sealed so that it can be used outdoors.

These objects have been achieved by a cabinet having the features recited in the claims.

The invention will be described in more detail hereinbelow with reference to the accompanying drawings.

Fig. 1 shows the cabinet from in front in the open servicing state with the door flaps moved apart.

Fig. 2 is a detail view taken along the line 2-2, which illustrates the cabinet when closed.

The instrument cabinet illustrated in the drawings is parallelepipedal having right angles and is mounted on a frame (not shown). On a rear wall 1, opposed side walls 2 are screwed, in which there are mounted articulated members or flaps 3 of L-shaped cross-section. One leg 3a, 3b thereof is adapted to form the top and bottom walls of the cabinet. Said articulation is provided by means of hinges 4 formed of pins which can be locked by screws from inside the cabinet and which engage in holes provided adjacent the longitudinal edges of the top, bottom and side walls 3a, 3b and 2, respectively, so that the pins are not accessible from outside.

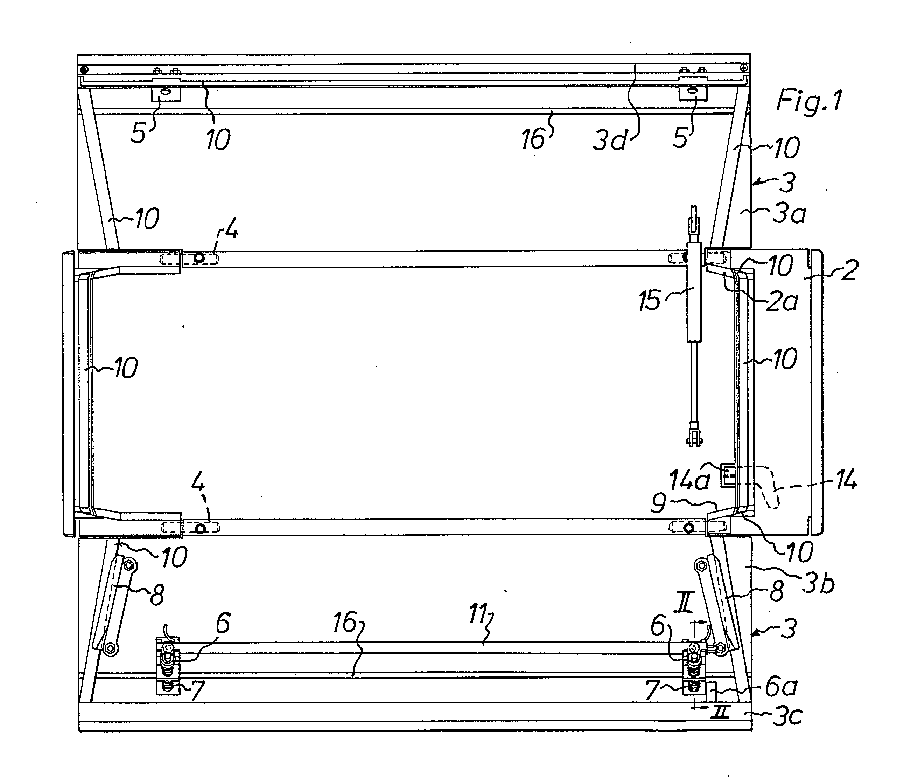

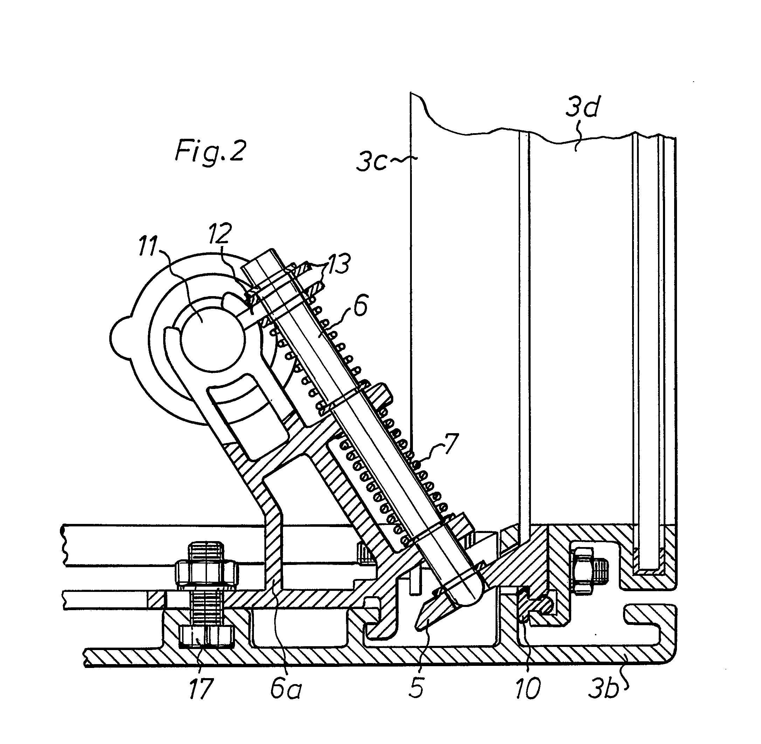

The other legs 3c, 3d of the flaps 3 are fixedly connected to the walls 3a and 3b, respectively, and adapted, when overlapping each other, to form a double wall of which the leg 3d forms the cabinet front wall and is wider than the leg 3c. In Fig. 1, the cabinet is illustrated in the open position accessible for maintenance with the flaps 3 moved apart. In Fig. 2, the cabinet is illustrated in the closed and locked position with the flaps 3 folded together and locked.

The locked state of the cabinet is defined by a locking snap engagement between the front wall 3d and the bottom wall 3b. To ensure this engagement, there are provided adjacent the free longitudinal edge of the front wall 3d apertured ears 5 mounted on the inner side of the front wall, and longitudinally slidable, spring-biased pins which are mounted on the inner side of the bottom wall 3b and arranged for snap engagement in the holes of the ears 5 and so mounted that this engagement takes place from the camming top face of the ears with untensioning of the spring 7. To permit said snap engagement, openings are provided in the wall 3c for allowing passage of the ears 5.

To facilitate the locking operation, obliquely directed leaf springs 8 are fixedly mounted on the bottom wall 3b and so arranged that when the lower flap is swung up they cam over lugs 9 on the inner side of the side walls 2 and snap into a resting position on these lugs for engagement therewith.

Yieldable sealing strips 10 are arranged on the walls 1, 2, 3a-3d with such a location that the cabinet is sealing in the locked state, i.e. when there is a snap engagement between the pins 6 and the ears 5, which snap engagement ensures proper sealing. In the illustrated embodiment, the side walls 2 are provided with internal strips 2a on which sealing strips 10 are mounted and with which the top and bottom walls 3a, 3b are adapted to engage, optionally via sealing strips of their own, the top and bottom edge surfaces of the side walls being aligned with the outer surfaces of the top and bottom walls, respectively. In the illustrated embodiment, the upper and lower sealing strips of the side walls 2 and the sealing strips of the top and bottom walls are arranged obliquely in relation to the transverse direction of the walls 3a, 3b.

A mechanism for opening the cabinet comprises a rod 11 rotatably mounted on the bottom 3b in the holders 6a of the pins and the springs 7. The rod 11 has a projection 12 fixedly connected thereto and adapted for such concealed engagement with the pins 6, e.g. by locking washers 13 mounted on the pins 6, that when the rod 11 is rotated, said engagement lifts the pins 6 out of their engagement with the ears 5.

For rotating the rod 11, there is provided on the outer side of one side wall 2 (here, the right one) a handle 14 which is non-rotatably connectible to the rod 11 by means of a pin 14a provided on the handle 14 and extending through the side wall and having a slot for engagement with the bevelled end of the rod when the bottom wall 3b has been swung up. Rotation of the handle 14 entails rotation of the rod 11 and, by the engagement between the projection 12 of the rod and the locking washers 13, also lifting of the pins 6 against the bias of the springs 7, out of the holes of the ears 5. The upper flap can now be folded up and the lower flap folded down, in the latter case while overcoming the action of the springs 8.

The handle 14 is enclosed in a lateral lockable cabinet space which is not shown in more detail in the drawings, but the inner wall of which is identical with the outer side of the side wall 2 and which has a cover with a lock which is manually openable and lockable by means of a key.

A piston cylinder 15 is adapted to maintain the upper flap 3 in the raised state.

The top and bottom walls 3a, 3b are identically designed and provided with internal ridges 16 (of which only one is shown) for mounting different instruments/instrument peripheral equipment and mounting components of which some have been mentioned above. The rear wall 1 of the cabinet is also intended to serve as a location for fixing components of the above-described type.

Screws/nuts for mounting said instruments, components etc., are countersunk in the walls so as to be inaccessible from the outside, see e.g. the nut and screw assembly 17 in Fig. 2.

It is evident that the cabinet can be doubled, with the rear wall 1 common to the two cabinet compartments.

In the open state of the cabinet, all components on the inner walls thereof are easily accessible.

The double wall 3c, 3d in the illustrated embodiment is used since the wall 3c is provided with instruments which should be visible from outside, e.g. a display, and protected from damage/moisture. The front wall 3d comprises a panel of shatter-proof transparent material.

## Claims

1. An instrument cabinet having rigid walls, **characterized** in that it has a first wall (1) and, fixed thereto, opposed second and third walls (2), opposed fourth and fifth walls (3a, 3b) articulated to the first wall (1) or the second and third walls (2), and a sixth wall (3d) opposed to said first wall and fixedly connected to the fourth or the fifth wall and having means (5) fixed thereto for concealed snap engagement with corresponding means (6, 7) fixed on said fourth or fifth wall, said snap engagement being releasable from the outer side of any of said walls by means of a key.

2. Cabinet as claimed in claim 1, **characterized** in that said walls have sealing strips (10) which are so disposed that said snap engagement defines a cabinet sealing.

3. Cabinet as claimed in claim 1 or 2, **characterized** in that said snap means (5, 6, 7) consist of apertured ears (5) fixed on said sixth wall, and spring-biased slidable pins (6) fixed to said fourth or fifth wall, said pins being so located and spring-biased as to counteract release of the locking engagement by tractive forces on said fourth or fifth wall.

4. Cabinet as claimed in claim 3, **characterized** in that a rod (11) is rotatably mounted in the holders of the pins (6) and, when the cabinet is closed, engages with a handle (14) adapted to lift the pins out of the engagement with said ears when the handle is rotated.

5. Cabinet as claimed in claim 4, **characterized** in that the handle is disposed in a space which can be locked by said key and the inner wall of which is defined by any of said walls.

Fig.1

Fig.2